# EUROPEAN PATENT APPLICATION

(11) **EP 0 613 248 A1**
(43) Date of publication of application: **31.08.1994**
(21) Application number: 94300320.2
(22) Date of filing: 17.01.1994
(51) Int. Cl.: H03K 19/018, H03K 19/003, H03F 3/50

(54) **Integrated circuit amplifiers**

(30) Priority: 17.02.1993 GB 9303137
(71) Applicant: PLESSEY SEMICONDUCTORS LIMITED, Swindon, Wiltshire SN2 2QW (GB)
(72) Inventor: Laws, Peter Graham, Swindon, Wiltshire SN5 5AG (GB)
(74) Representative: Hoste, Colin Francis

(57) **Abstract**

In a Class B integrated circuit amplifier having a complementary symmetry emitter follower-type output stage, an NPN transistor (Q5) is connected effectively in parallel with the PNP output transistor (Q4) and is arranged to draw a current dependent upon the current flowing in the emitter-collector path of the PNP transistor (Q4), to compensate for the relatively poor characteristics of the PNP transistor (4).

## Description

The present invention relates to integrated circuit amplifiers. In particular although not exclusively the invention is concerned with a power efficient output drive circuit suitable for prescalers fabricated on high speed bipolar silicon processes. The technique is also suitable for other types of circuits incorporating ECL type output drives.

Prescalers normally have a standard ECL type output drive. This consists of an emitter follower transistor biased with a constant pull down current provided by a current source or an external resistor. This results in a class A type output drive stage.

Many high speed bipolar processes support good NPN transistors, but have relatively poor lateral PNPs. These PNP transistors operate in the lateral plane resulting in moderate Ft and poor current handling capability.

The output driver proposed uses a class B output drive stage, utilising a complementary PNP active pull down circuit. This results in an energy efficient output drive circuit.

This circuit is suitable for low voltage (2.7 volt) prescalers and has the added advantage of being able to be powered down when required for battery economy purposes.

According to the present invention an integrated circuit amplifier comprises an NPN junction transistor and a PNP junction transistor having their respective emitter-collector paths connected between an output terminal and positive and negative supply lines respectively and means to supply input signals to their respective base electrodes, and a further NPN junction transistor having its collector-emitter path connected effectively in parallel with the emitter-collector path of said PNP junction transistor and arranged to draw a current dependent upon the current flowing through the emitter-collector path of said PNP transistor.

Preferably the base-emitter path of said further NPN junction transistor is connected in parallel with a collector load resistor for said PNP junction transistor.

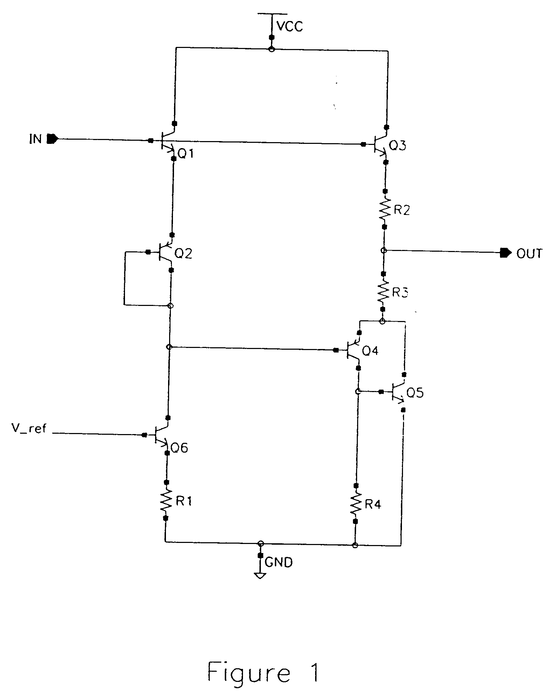

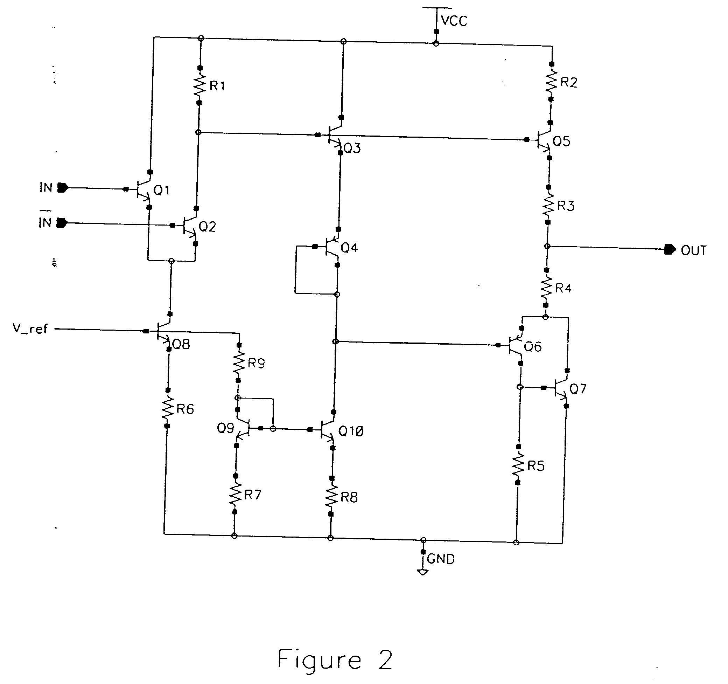

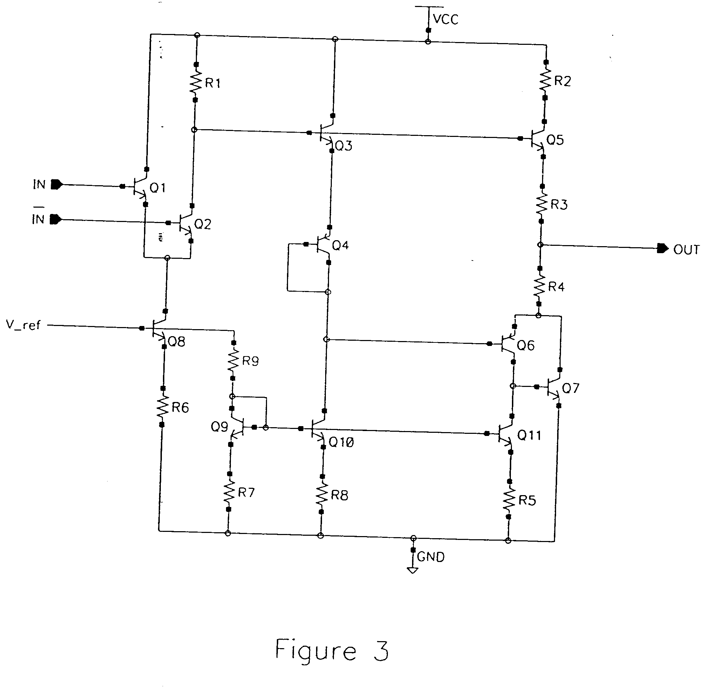

Amplifiers in accordance with the present invention will now be described by way of example with reference to the accompanying drawings, of which Figures 1 to 3 show diagrammatically three different embodiments.

The basic circuit principles are described with reference to Figure 1. From this circuit it can be seen that Q3 and Q4 with Q5 provide a low impedance emitter follower output drive arrangement. These transistors are biased for a low quiescent current by means of matched transistors Q1 and Q2, the Vbe's of Q1 and Q2 being dependent on the current source provided by Q6 and R1. V ref is a voltage reference, generated on chip to provide biasing for constant current sources.

Transistor Q4's quiescent current is determined by R4 and the Vbe of Q5. Since this current will be relatively small to obtain optimum operating conditions for the PNP, it will have an associated low Vbe voltage. This can be compensated for in the biasing arrangement by increasing the effective emitter size of Q1, hence reducing its Vbe voltage.

In dynamic operation the circuit acts as a (unity gain) buffer amplifier with the output signal tracking one Vbe below the input drive signal.

Resistors R2 and R3 serve two purposes. The first is to minimise any current increase in the output drive transistors due to Vbe variations caused by non ideal matching conditions and on chip temperature gradients. The second purpose is to provide damping when driving capacitive loads.

Figure 2 shows how the basic circuit may be driven from a differential input stage. The current source arrangement provided by Q9, Q10, R9, R7 and R8 show how maximum output voltage swing can be obtained, this being particularly useful for low voltage applications. This arrangement also provides increased isolation between the drive signal present on the collector of Q10 and the internal voltage reference (V ref).

Figure 3 shows an alternative circuit arrangement for setting the bias current in transistor Q6. In this case a load current source is provided by Q11 and R5.

## Claims

1. An integrated circuit amplifier comprising an NPN junction transistor and a PNP junction transistor having their respective emitter-collector paths connected between an output terminal and positive and negative supply lines respectively and means to supply input signals to their respective base electrodes, and a further NPN junction transistor having its collector-emitter path connected effectively in parallel with the emitter-collector path of said PNP junction transistor and arranged to draw a current dependent upon the current flowing through the emitter-collector path of said PNP transistor.

2. An amplifier in accordance with Claim 1 wherein the base-emitter path of said further NPN junction transistor is connected in parallel with a collector load resistor for said PNP junction transistor.

3. An integrated circuit amplifier comprising a first NPN junction transistor and a first PNP junction transistor having their respective emitter-collector paths connected between an output terminal of the amplifier and positive and negative supply lines respectively, and a second NPN junction transistor having its collector-emitter path connected effectively in parallel with the emitter-collector path of said first PNP transistor and arranged to draw a current dependent upon the current flowing through the emitter-collector path of said first PNP transistor, wherein means to apply input signals to the base electrodes of said first NPN transistor and said first PNP transistor comprises a third NPN junction transistor and a second PNP junction transistor having their collector-emitter and emitter-collector paths, respectively, connected in series with a source of substantially constant current in that order between said positive and negative supply lines, input signals being applied in common to the base electrodes of said first and third NPN transistors and the base and collector electrodes of said second PNP transistor being connected together and to the base electrode of said first PNP transistor.

4. An integrated circuit amplifier in accordance with Claim 3 wherein the base-emitter path of said second NPN transistor is connected in parallel with collector load means for said first PNP transistor.

5. An integrated circuit amplifier in accordance with Claim 3 or Claim 4 wherein respective current-limiting resistors are connected between the emitter electrode of said first NPN transistor and said output terminal and between the emitter electrode of said first PNP transistor and said output terminal.
